# EUROPÄISCHE PATENTANMELDUNG

(11) **EP 0 790 678 A2**
(43) Veröffentlichungstag der Anmeldung: **20.08.1997**
(21) Anmeldenummer: 97400347.7
(22) Anmeldetag: 17.02.1997
(51) Int. Cl.: H01S 3/025, G02B 6/42

(54) **Anordnung zur optischen Ankopplung einer Monitordiode an eine Laserdiode**

(30) Priorität: 16.02.1996 DE 19605726
(71) Anmelder: ALCATEL ALSTHOM COMPAGNIE GENERALE D'ELECTRICITE, 75008 Paris (FR)
(72) Erfinder: Hehmann, Jörg, 70499 Stuttgart (DE)
(74) Vertreter: Schätzle, Albin, Dipl.-Phys.

(57) **Zusammenfassung**

Bei einer Anordnung zur optischen Ankopplung einer Monitordiode (11) an eine kantenemittierende Laserdiode (6) sind beide Dioden auf einem Trägerplättchen (1) aus Silizium durch eine V-Nut (7) getrennt, hintereinander angeordnet. An dem der Laserdiode (6) benachbarten Nutende (8) ist in der V-Nut (7) eine emittiertes Rücklicht sammelnde Kugellinse (10) fixiert, deren optische Achse unterhalb der optischen Achse des Laserrücklichts liegt und das gesammelte Rücklicht auf das andere Nutende (9) fokussiert. Dieses Nutende (9) ist verspiegelt und reflektiert das Rücklicht in die aktive Zone der über der Verspiegelung auf dem Trägerplättchen (1) befestigten Monitordiode (11).

## Beschreibung

Die Erfindung betrifft eine Anordnung zur optischen Ankopplung einer Monitordiode an eine Laserdiode, die in einer Ebene hintereinander auf einem Trägerplättchen fixiert und so durch eine V-Nut mit schräg auslaufendem, verspiegelten Nutende voneinander getrennt sind, daß von der Laserdiode emittiertes Rücklicht vom verspiegelten Nutende zur Monitordiode reflektiert wird. Derartige Koppelanordnungen werden insbesondere in Systemen der optischen Nachrichtentechnik verwendet.

Eine Koppelanordnung der im Oberbegriff des Patentanspruchs 1 näher bezeichneten Ausführung ist aus der DE-C-43 13 492 bekannt. Bei dieser Koppelanordnung wird eine kantenemittierende Laserdiode verwendet, von deren Rücklicht jedoch nur höchstens die Hälfte in die V-Nut strahlt. Damit von dem wenigen Streulicht möglichst viel zur Monitordiode reflektiert wird, sind die schrägen Stirn- und Seitenflächen der V-Nut voll verspiegelt.

Der Erfindung liegt die Aufgabe zugrunde, den Wirkungsgrad der optischen Ankopplung so zu verbessern, daß möglichst das gesamte von der Laserdiode abgestrahlte Rücklicht von der Monitordiode empfangen werden kann. Diese Aufgabe wird erfindungsgemäß von einer optischen Koppelanordnung mit den Merkmalen des Patentanspruchs 1 gelöst. Ausgestaltungen der Koppelanordnung sind den Unteransprüchen zu entnehmen.

Der mit der Erfindung erzielbare Vorteil besteht unter anderem darin, daß wegen der von der Monitordiode detektierten hohen Signalintensität die Regelelektronik zur Steuerung der Laserdiode schaltungstechnisch einfacher ausgelegt werden kann. Damit entfällt der sonst erforderliche höhere Aufwand für die Signalaufbereitung innerhalb der Verstärkerschaltung.

Die Erfindung wird anhand eines in einer Zeichnung dargestellten Ausführungsbeispiels wie folgt näher beschrieben. In der Zeichnung zeigen:
- Fig. 1: eine schematisch dargestellte optische Koppelanordnung, teilweise längsgeschnitten, in einer Seitenansicht;
- Fig. 2: einen Ausschnitt der optischen Koppelanordnung gemäß Fig. 1, in der Draufsicht.

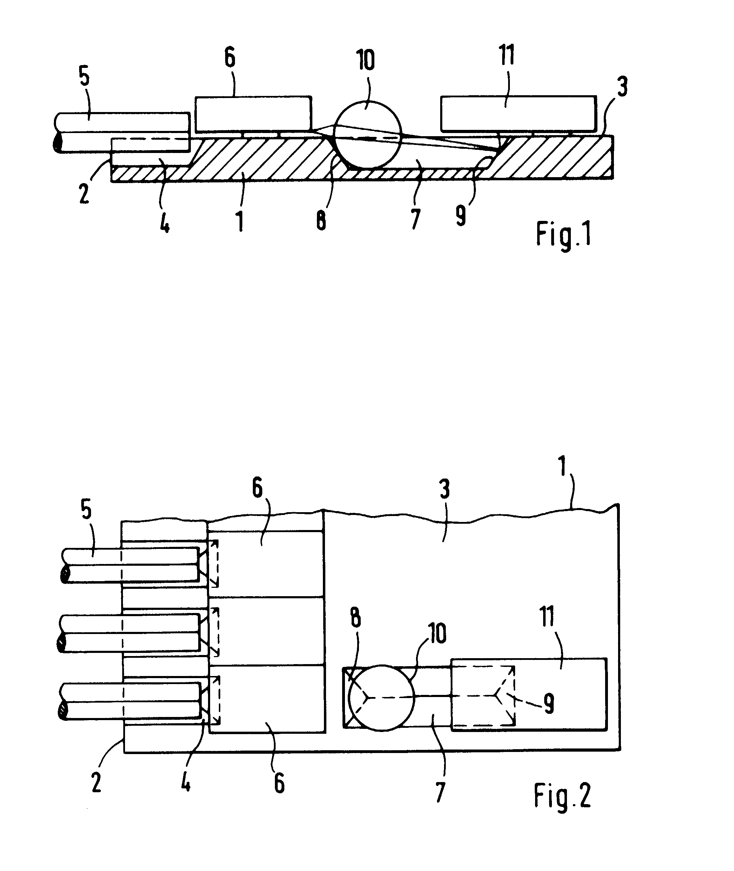

In den Fig. 1 und 2 ist ein Trägerplättchen der optischen Koppelanordnung mit 1 bezeichnet. Es besteht aus Silizium und hat in mehreren Reihen parallel nebeneinander liegende Koppelanordnungen. Da deren Aufbau und Funktionsweise jeweils identisch ist, wird im folgenden nur eine erläutert.

Im Bereich einer Stirnseite 2 weist das Trägerplättchen 1 eine in die Oberfläche 3 eingearbeitete, an der Stirnseite 2 offene V-Nut 4 mit darin fixierter Glasfaser 5 auf. Vor dem Faserende ist auf dem Trägerplättchen 1 eine kantenemittierende Laserdiode 6 befestigt, die Signallicht in die Glasfaser 5 strahlt. Hinter der Laserdiode 6, also an der Rücklicht emittierenden Seite ist eine weitere V-Nut 7 im Trägerplättchen 1 vorgesehen, die, wie auch die zuvor erwähnte, durch anisotropes Ätzen hergestellt ist und daher nicht nur einen V-förmigen Querschnitt, sondern in diesem Fall auch zwei schräg auslaufende Nutenden 8, 9 hat. Die seitlichen Nutflanken und die Flanken der Nutenden haben hier dieselbe Steigung.

An dem der Laserdiode 6 benachbarten Nutende 8 ist eine Kugellinse 10, beispielsweise mit einem Kleber so in der V-Nut 7 befestigt, daß sie an allen drei Flanken aufliegt. Die Lage und Breite dieser V-Nut 7 wird so ausgewählt, daß die Kugellinse 10 in optimaler Position zum Laserkanal liegt. Der Abstand der Kugellinse 10 zur Laserdiode 6 wird über die Flanke des entsprechenden Nutendes 8 definiert und die Höhe der optischen Achse der Kugellinse 10 unter Berücksichtigung ihres Durchmessers durch die Breite der V-Nut 7 festgelegt. Dabei wird die Breite der V-Nut 7 so gewählt, daß die optische Achse der Kugellinse 10 unterhalb der optischen Achse der Laserdiode 6 liegt.

Als geeignet hat sich die Verwendung einer handelsüblichen Kugel linse 10 herausgestellt, die beispielsweise einen Durchmesser von etwa 150 µm und eine Brechzahl von annähernd 1.5 hat. Hierbei beträgt die Länge der die Kugellinse 10 aufnehmenden V-Nut 7 zwischen den Kanten an der Oberfläche 3 des Trägerplättchens 1 ca. 500 µm. Unter diesen Bedingungen wird erreicht, daß von der Laserdiode 6 emittiertes Rücklicht auf das andere Nutende 9 fokussiert wird. Dieses Nutende 9 ist mit einer aufgedampften Metallschicht versehen, die als Umlenkspiegel wirkt und auftreffendes Rücklicht zu einer Monitordiode 11 reflektiert. Die Monitordiode 11 ist so auf der Oberfläche 3 des Trägerplättchens 1 angeordnet, daß deren aktive Zone sich unmittelbar über dem verspiegelten Nutende 9 befindet.

Natürlich können für das Trägerplättchen 1 anstelle von Silizium auch andere Werkstoffe sowie Nute und Kugellinsen mit darauf entsprechend abgestimmten Abmessungen verwendet werden.

Entscheidend ist, daß die optische Achse der Kugellinse 10 unterhalb der optischen Achse der Laserdiode 6 liegt und das gesammelte Rücklicht auf dem Umlenkspiegel abgebildet wird.

Bei dem beschriebenen Aufbau der Koppelanordnung sind somit in einer Längsachse hintereinander angeordnet: eine vordere V-Nut 4 mit Glasfaser 5, die Laserdiode 6, eine weitere V-Nut 7 mit eingelagerter Kugellinse 10 und verspiegeltem Nutende 9 sowie die Monitordiode 11. Die Vorteile basieren unter anderem in der sehr genauen Herstellungsmöglichkeit der V-Nute 8, 9 mit der dadurch möglichen präzisen Anordnung der Teilkomponenten 5, 10, 9 einschließlich der mittels Thermokompressionsbonden exakten Befestigung von Laser- und Monitordiode 6, 11 auf dem Trägerplättchen 1, das ohne weiteres bedarfsweise für eine oder mehrere zeilenförmige Koppelanordnungen ausgebildet sein kann.

## Patentansprüche

1. Anordnung zur optischen Ankopplung einer Monitordiode an eine Laserdiode, die in einer Ebene hintereinander auf einem Trägerplättchen fixiert und so durch eine Nut mit schräg auslaufendem, verspiegelten Nutende voneinander getrennt sind, daß von der Laserdiode emittiertes Rücklicht vom verspiegelten Nutende zur Monitordiode reflektiert wird,
**dadurch gekennzeichnet**, daß in der Nut (7) hinter der Laserdiode (6) eine Kugellinse (10) zum Sammeln des emittierten Rücklichts angeordnet ist, die das Rücklicht auf das verspiegelte Nutende (9) fokussiert.

2. Optische Koppelanordnung nach Patentanspruch 1, dadurch gekennzeichnet, daß die optische Achse der Kugellinse (10) unterhalb der optischen Achse des emittierten Laserrücklichts liegt.

3. Optische Koppelanordnung nach Patentanspruch 1, dadurch gekennzeichnet, daß die Kugellinse (10) an dem der Laserdiode (6) benachbarten Nutende (8) an drei Flanken einer V-förmigen Nut (7) aufliegend fixiert ist.

4. Optische Koppelanordnung nach einem der Patentansprüche 1 bis 3, dadurch gekennzeichnet, daß die Kugellinse (10) einen Durchmesser von etwa 150 µm und eine Brechzahl von annähernd 1.5 hat und daß die Länge der die Kugellinse (10) aufnehmenden V-Nut (7) ca. 500 µm beträgt.
